# EUROPEAN PATENT APPLICATION

(11) **EP 2 293 337 A1**
(43) Date of publication of application: **09.03.2011**
(21) Application number: 09770009.0
(22) Date of filing: 08.06.2009
(51) Int. Cl.: H01L 29/78, H01L 21/28, H01L 29/417, H01L 29/739

(54) **SEMICONDUCTOR DEVICE AND METHOD FOR FABRICATING THE SAME**

(30) Priority: 26.06.2008 JP 2008167176
(71) Applicant: Sanken Electric Co., Ltd., Niiza-shi Saitama 352-8666 (JP)
(72) Inventor: TORII, Katsuyuki, Niiza-shi Saitama 352-8666 (JP); SUGIYAMA, Kinji, Niiza-shi Saitama 352-8666 (JP)
(74) Representative: Grünecker, Kinkeldey, Stockmair & Schwanhäusser Anwaltssozietät
(86) International application number: PCT/JP2009/060459
(87) International publication number: WO 2009/157299

(57) **Abstract**

A semiconductor device fabricated by a method of the invention includes a first semiconductor layer (1), a second semiconductor layer (4) on the first semiconductor layer (1), a third semiconductor layer (5) on the second semiconductor layer (4) and being in the shape of an island on the second semiconductor layer (4), a dielectric film (7) on the second and third semiconductor layers (4) and (5), a control electrode (21) on the dielectric film (7), a first main electrode (22) electrically connected to the second and third semiconductor layers (4) and (5), and a second main electrode (23) electrically connected to the first semiconductor layer (1) and having a Pd layer.

## Description

### [Technical Field]

This invention relates to a semiconductor device including insulated gate type semiconductor elements and a method of fabricating the semiconductor device.

### [Background Art]

An IGBT (Insulated Gate Bipolar Transistor) is known as a power semiconductor element which can simultaneously allow high speed operation of a MOSFET (Metal Oxide Semiconductor Field Effect Transistor) and a low on-state voltage of a bipolar transistor.

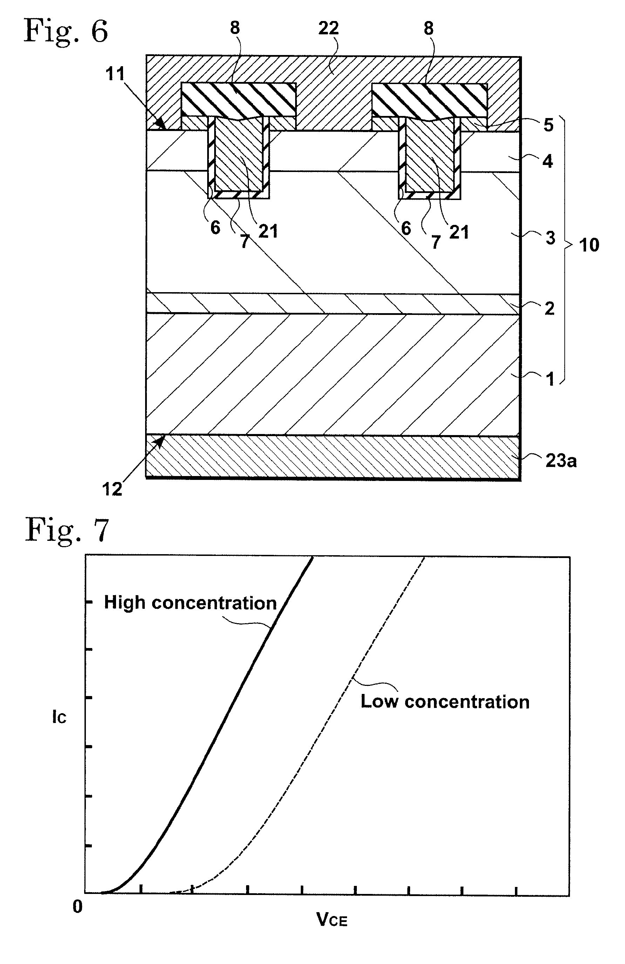

Fig. 6 of the accompanying drawings is a side cross-sectional view of an existing punch-through type IGBT. The IGBT includes a semiconductor layer which is constituted by a p+ type collector layer 1, an n+ type buffer layer 2, an n- type drift layer 3, a p- type base layer 4, and an n+ type emitter layer 5. Further, the IGBT has the following: a trench 6 extending from a main surface of the semiconductor layer 10 to the drift layer 3; a insulated gate film 7; a gate electrode 21 formed in the trench 6; an interlayer dielectric film 8 extending on the emitter layer 5 and the gate electrode 21; an emitter electrode 22 extending on the base layer 4, the emitter layer 5 and the interlayer dielectric film 8; and a Ti (titanium) collector electrode 23a formed on a main surface 12 of the collector layer 1.

Generally, IGBTs are classified into punch-through types and non-punch-through types depending upon their structures. Especially, with the punch-through type IGBTs, the buffer layer 2 forcibly suppresses a depletion layer from spreading from the drift layer 3 to the collector layer 3 when a reverse voltage is applied from the drift layer 3 to the collector layer 1. This allows thinning of the drift layer 3 having a relatively high resistance. Further, the punch-through type IGBTs can operate on a low on-state voltage.

Further, IGBTs have a unique breakdown mode called a latch-up phenomenon. The phenomenon is caused by operation of a parasitic thyristor built in the IGBT. During normal operation, hole currents applied from the collector layer 1 flow through a gate of the parasitic thyristor, thereby operating the thyristor.

In order to prevent the latch-up phenomenon, it is known to use the collector layer 1 having a low impurity concentration and to suppress an amount of hole currents to be applied. This method is effective in preventing the latch-up phenomenon by decreasing hole currents. However, it is very difficult to assure good contact between the low impurity concentration collector layer 1 and the collector electrode 23a, i.e. good Ohmic contact is difficult to be accomplished, and Schottky contact is easily caused. As a result, an on-state voltage is raised as shown in Fig. 7. Further, when started up, the thyristor operates in an unstable state in which an output voltage V_{CE} and an output current I_{C} are not proportional.

Refer to Patent Citation 1 with respect to the IGBT.

### [Patent Citation 1]

Japanese Patent Laid-Open Publication No. 2005-197472

### [Disclosure of Invention]

### [Technical Problem]

The foregoing phenomenon depends upon a relationship between an electron affinity Xs of the collector layer 1 and a work function ϕₘ of the collector electrode 23a. The collector layer 1 is assumed to be of p+ type. The lower the impurity concentration of a surface of the collector layer 1, the larger the electron affinity Xs. As a difference (X_{S} - ϕₘ) becomes larger, the Schottky contact tends to be easily made.

In order to overcome this problem, a method of locally forming a high concentration region is known, in which the collector layer 1 is thinned, and p type impurities are applied only to the main surface 12 of the collector layer 1. With the foregoing method, the electron affinity Xs of the collector layer 1 is reduced, and the difference (X_{S} - ϕₘ) is also reduced or becomes negative. Therefore, an Ohmic contact is accomplished, so that a low on-state voltage is obtained.

For the foregoing purpose, the following processes are however necessary up to now: to implant p type ions onto the main surface 12 of the collector layer 1, and to perform annealing in order to activate the p type ions. This will inevitably lead to an increase of a fabricating cost. In addition, with the existing processes, the gate electrode 21 and the emitter electrode 22 are formed on the semiconductor layer 10, and the collector layer 1 is thinned from the main surface 12 in a polishing process. Thereafter, ion implant and annealing processes are carried out. In process after the thinning process, the IGBT tends to be easily destroyed, which will lead to a lowered fabrication yield.

This invention has been contemplated in order to overcome the foregoing problems of the related art, and is intended to provide a semiconductor device which can prevent the latch up phenomenon and improve a fabricating yield of the semiconductor device. Further, the invention aims at providing a method of fabricating the semiconductor device with an increased yield.

### [Technical Solution]

In order to overcome the foregoing problems, a semiconductor device includes: a first semiconductor layer having a first conductivity type or a second conductivity type opposite to the first conductivity type; a second semiconductor layer formed on the first semiconductor layer and having the first conductivity type; a third semiconductor layer formed in the shape of an island on the second semiconductor layer and having the second conductivity type; a dielectric film formed on the second semiconductor layer and the third semiconductor layer; a control electrode formed on the dielectric film; a first main electrode electrically connected to the second semiconductor layer and the third semiconductor layer; and a second main electrode electrically connected to the first semiconductor layer and having a Pd layer.

The semiconductor device is fabricated as follows: forming a first semiconductor layer having a first conductivity type or a second conductivity type opposite to the first conductivity type; forming a second semiconductor layer on the first semiconductor layer, the second semiconductor layer having the first conductivity type; forming a third semiconductor layer in the shape of an island on the second semiconductor layer, the third semiconductor layer having the second conductivity type; forming a dielectric film on the second semiconductor layer and the third semiconductor layer; forming a control electrode on the dielectric film; forming a first main electrode on the second semiconductor layer and the third semiconductor layer; and forming a second main electrode on the first semiconductor layer, the second main electrode having a Pd layer.

### [Advantageous Effects]

The invention can provide the semiconductor device which can prevent the latch up phenomenon and assure a low on-state voltage. Further, the invention can offer the method of fabricating the semiconductor device at an improved yield.

### [Brief Description of Drawings]

Fig. 1 is a side elevation of a semiconductor device according to a mode 1 of the invention.
Fig. 2 is a sectional view showing how the semiconductor device is formed in a first fabricating process.
Fig. 3 is a sectional view showing a second fabricating process.
Fig. 4 is a sectional view showing a third fabricating process.
Fig. 5 is a side elevation of a semiconductor device according to a mode 2 of the invention.
Fig. 6 is a side elevation of an IGBT in the related art.
Fig. 7 is a correlation chart showing properties of an output voltage V_{CE} and an input voltage I_{C} of the IGBT in the related art.

### [Best Modes for Carrying out the Invention]

The invention will be described with reference to the drawings. Hereinafter, like or corresponding parts are denoted by like or corresponding reference numerals. The drawing figures are schematic, and some of components shown therein may differ from those of actual components. Still further, scales and ratios of drawings may be sometimes different.

The following modes exemplify devices and methods for accomplishing the technical concept of the invention. The technical concept of the invention is not limited to the arrangement of components described hereinafter. Further, various modifications and variations could be made to the technical concept without departing from the scope of the invention set forth in the claims.

### [Mode 1 of the Invention]

In a mode 1, the invention is applied to a semiconductor device including a punch-through type IGBT with the trench structure.

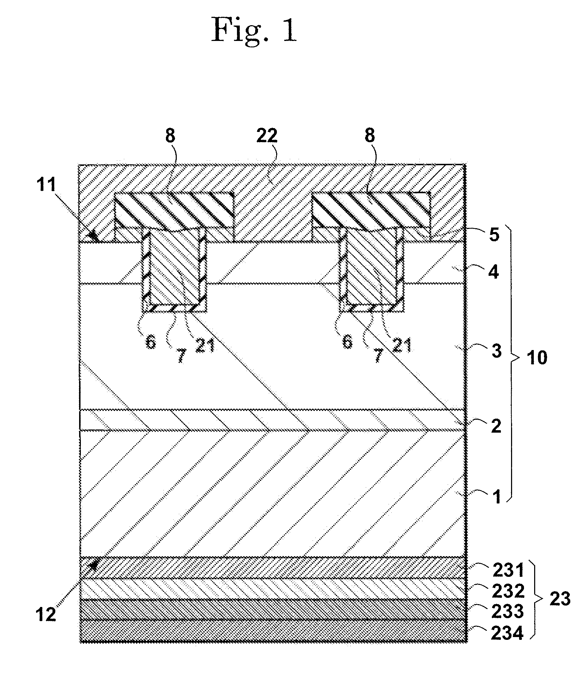

Referring to Fig. 1, the IGBT includes the following: a first semiconductor layer 1 with a first conductivity type; a fourth semiconductor layer 2 formed on the first semiconductor layer 1 and with a second conductivity type which is opposite to the first conductivity type; a fifth semiconductor layer 3 formed on the fourth semiconductor layer 2 with the second conductivity type; a second semiconductor layer 4 formed on the fifth semiconductor layer 3 and with the first conductivity type; a third semiconductor layer 5 formed on the second semiconductor 4 in the shape of an island and with the second conductivity type; a dielectric film 7 formed on the second semiconductor layer 4 and the third semiconductor layer 5; a control electrode 21 formed on the dielectric film 7; a first main electrode 22 electrically connected to the second semiconductor layer 4 and the third semiconductor layer 5; and a second main electrode 23 electrically connected to the first semiconductor layer 1 and having a Pd (palladium) layer.

In the mode 1, the first conductivity type is p type while the second conductivity type is n type. The semiconductor layer 1 of the first conductivity type is a p+ type collector layer. The fourth semiconductor layer 2 of the second conductivity type is an n+ type buffer layer. The fifth semiconductor layer 3 of the second conductivity type is an n- type drift layer. The second semiconductor layer 4 of the first conductivity type is a p type base layer. The third semiconductor layer 5 of the second conductivity type is an n+ type emitter layer. The control electrode 21 functions as a gate electrode. The first, fourth, fifth, second and third semiconductor layers 1, 2, 3, 4 and 5, the dielectric film 7 and the control electrode 21 constitute the punch-through type IGBT.

The first, fourth, fifth, second and third semiconductor layers 1 to 5 made in silicon are used as wafers during the fabricating process, and constitute a semiconductor layer 10, which is used as segmentalized chips in processes after a dicing process.

With the IGBT having the trench structure in the mode 1, the trench 6 extends between one main surface 11 of the semiconductor layer 10 toward the other main surface 12, and reaches an inner part of the fifth semiconductor layer 3. The main surface 11 is an upper surface of the third semiconductor layer 5 as shown in Fig. 1 while the main surface 12 is the lower surface of the first semiconductor layer, and is opposite to the main layer 11. The dielectric film 7 extends on inner side surface and bottom surface of the trench 6. The control electrode 21 is housed in the trench 6 via the dielectric film 7.

The first main electrode 22 is formed on an inter layer dielectric film 8 extending on the second semiconductor layer 4, third semiconductor layer 5 and control electrode 21, and is electrically connected to the second and third semiconductor layers 4 and 5. In short, the first main electrode 22 is present on the main surface 11 of the semiconductor layer 10, and is made of an A1 (aluminum) layer, an A1 alloy layer or the like, for instance.

In the mode 1, the second main electrode 23 extends all over the front surface of the first semiconductor layer 1, i.e. the main surface 12 of the semiconductor layer 10. The second main electrode 23 is constituted by a Pd layer 231, a Ti (titanium) layer 232, an Ni (nickel) layer 233 and an Au (gold) layer 234 which are stacked on the first semiconductor layer 1 in series.

The Pd layer 231 reduces the difference (Xs - ϕₘ) or makes the difference negative in order to accomplish the Ohmic contact between the first semiconductor layer 1 and the second main electrode 23. In this case, the Pd layer 231 may be pure Pd or Pd silicide in order to accomplish the Ohmic contact. Alternatively, the Pd silicide itself may be deposited. Otherwise, the deposited Pd may be compounded with silicon of the first semiconductor layer 1 at the time of or after heat treatment, or may be totally or partly made to be silicide.

The Ti layer 232 functions as a barrier metal layer, keeps oxygen from getting mixed into an interface between the first semiconductor layer 1 and Pd layer 231, and prevents the first semiconductor layer 1 and Pd layer 231 from peeling off from the surface. The Ni layer 233 functions as an adhesion layer (an alloyed reaction layer) when the semiconductor device is assembled by the soldering process or the like. The Au layer 234 prevents oxidation of the Ni layer 233.

The Ni layer 233 may be formed by a user after the semiconductor device has been completed. However, when no solder is used, the Ni layer 233 may be dispensable in the mode 1. Further, the Au layer 234 may be dispensable.

In the mode 1, the second main electrode 23 includes the Pd layer 231, Ti layer 232, Ni layer 233 and Au layer 234. Alternatively, the second main electrode 23 may have a stacked structure of a Pd layer, Ti layer, Ni layer and Ag layer, or a stacked structure of a Pd layer, Ti layer, Ni layer, V (vanadium) layer and Ag layer.

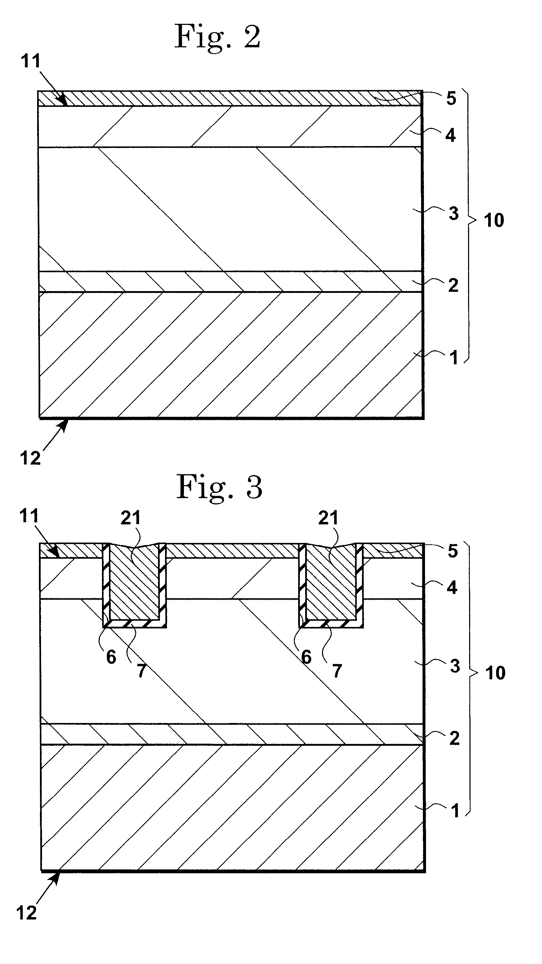

The semiconductor device of the mode 1 is fabricated as described hereinafter. The semiconductor layer 10 is formed as shown in Fig. 2. First of all, phosphor (P) as an n type impurity is diffused on the first semiconductor layer 1 (p+ type collector layer), so that the fourth semiconductor layer 2 (n+ type buffer layer) is formed. Thereafter, the fifth semiconductor 5 (n- type drift layer) is expitaxially grown on the fourth semiconductor layer 2. Boron (B) as a p type impurity is diffused on the fifth semiconductor layer 3, and the second semiconductor layer 4 (p type base layer) will be formed. Phosphor is diffused on the second semiconductor layer 4, and the third semiconductor layer 5 (n+ type emitter layer) will be formed. In the mode 1, the semiconductor layer 10 is provided with the fourth and fifth semiconductor layers 2 and 3. Alternatively, the semiconductor layer 10 may include only the fifth semiconductor layer 3.

Referring to Fig. 3, the trench 6 is made on the main surface 11 of the semiconductor layer 10. For this purpose, dry etching such as the reactive ion etching (RIE) is applied to the second semiconductor layer 3 and the third semiconductor layer 5 using a photolithographic mask, so that the trench 6 is patterned. The trench 6 extends to the third semiconductor layer 5. The trench 6 is provided with the dielectric film 7 on its inner surface using the thermal oxidation process. The dielectric film 7 is a silicon oxide film (SiO₂). Thereafter, a polycrystalline silicon film is applied onto the main surface 11 and the dielectric film 7 in the trench 6. The main surface 11 is chemically polished (using the CMP process), so that the control electrode 21 is made in the trench 6. The trench 6 and control electrode 21 are in the shape of stripes or dots or grid on their planar surfaces.

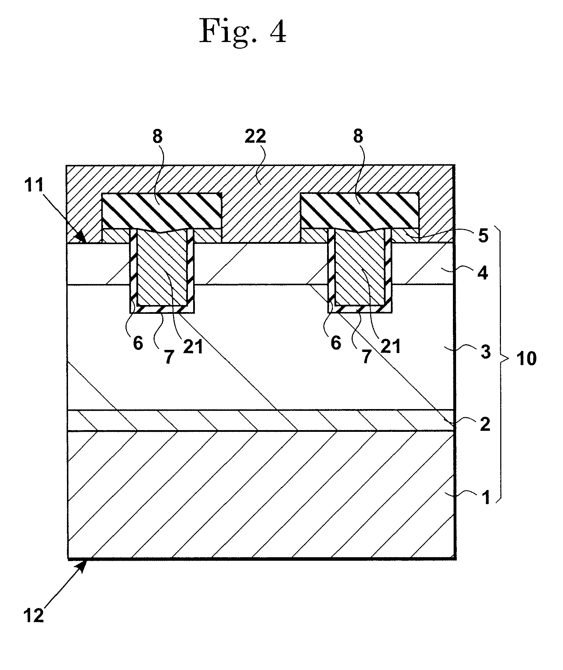

The inter layer dielectric film 8 is made on the third semiconductor layer 5, dielectric film 7 and control electrode 21 as shown in Fig. 4. The inter layer dielectric film 8 is a silicon oxide film formed by the CVD process. A contact hole is made in the third semiconductor layer 5, dielectric film 7 and inter layer dielectric film 8 by means of the method similar to the method of making the trench 6. The contact hole extends to the second semiconductor layer 4. As shown in Fig. 4, the first main electrode 22 is formed by the spattering process. The first main electrode 22 is made of Al.

The rear surface of the first semiconductor layer 1 is thinned by the back grind process on the main surface 12 of the semiconductor layer 10 (refer to Fig. 1). The Pd layer 231, Ti layer 232, Ni layer 233 and Au layer 234 are formed in series on the main surface of the first semiconductor layer 1, thereby making the second main electrode 23. The Pd layer 231 of the second main electrode 23 is chemically combined with Si of the first semiconductor layer 1 by thermal treatment at 100 °C to 150 °C at the time of or after the thermal treatment of the second main electrode 231, so that Pd silicide will be easily made at least on the interface of the Pd layer 231 and the first semiconductor layer 1.

The semiconductor device fabricating method of the mode 1 includes the process for making the second main electrode 23 having the Pd layer 231, and differs from an existing IGBT fabricating method in this respect. The remaining fabricating process of the components except for the second main electrode 23 is the same as that of the existing IGBT fabricating method.

With the fabricating method of the mode 1, the first semiconductor layer 1 is 50 µm to 300 µm thick, for instance. The fourth semiconductor layer 5 is 2 µm to 20 µm thick, for instance. The fifth semiconductor layer 3 is 20 µm to 70 µm thick, for instance. The impurity concentration of the first semiconductor layer 1 is 1 × 10¹⁶ cm⁻³ to 1 × 10¹⁹ cm⁻³, for instance, and is preferably 5 × 10⁷ cm⁻³ to 8 × 10¹⁸ cm⁻³. The impurity concentration of the fourth semiconductor layer 2 is 5 × 10¹⁶ cm⁻³ to 5 × 10¹⁸ cm⁻³, for instance. The impurity concentration of the fifth semiconductor layer 3 is 5 × 10¹³ cm⁻³ to 5 × 10¹⁵ cm⁻³, for instance.

With the IGBT of the semiconductor device in the mode 1, the second electrode 23 includes the Pd layer 231, which is effective in reducing the difference (X_{S} - ϕₘ) between the electron affinity X_{S} of the first semiconductor layer 1 and a work function ϕₘ of the second electrode 23, or making the difference negative. Therefore, the Ohmic contact is accomplished for the first semiconductor layer 1 and the second main electrode 23, so that the on-state voltage can be lowered, and stable operation can be assured. The impurity concentration of the first semiconductor layer 1 is 5 × 10¹⁷ cm⁻³ to 8 × 10¹⁸ cm⁻³, which is one digit smaller than the impurity concentration of existing IGBTs. This is effective in controlling an injection volume of holes during the operation of the IGBTs, and preventing the latch-up phenomenon.

With the fabricating method of the semiconductor device in the mode 1, the second main electrode 23 having the stacked structure can be made in the same spattering apparatus in a continuous process. Therefore, the number of the fabricating processes is not increased, and no special post processing is necessary, which is effective in fabricating the semiconductor device at a low cost and with good yields.

Further, the invention is not limited to the foregoing semiconductor device and the fabricating method but is applicable to other components. For instance, the invention is effectively applicable not only to punch-through type IGBTs but also to non-punch-through type IGBTs or IGBTs having the planar structure. When the present invention is used for a semiconductor device having the foregoing IGBTs, the semiconductor device is as effective and advantageous as the semiconductor device of the mode 1. Still further, when the Pd layer is present nearest the main surface 12, the second main electrode 23 may have the stacked structure in which other electrode materials are used.

### [Mode 2 of the Invention]

In a mode 2, the invention is applied to a semiconductor device which includes a vertical power MOSFET of the trench structure.

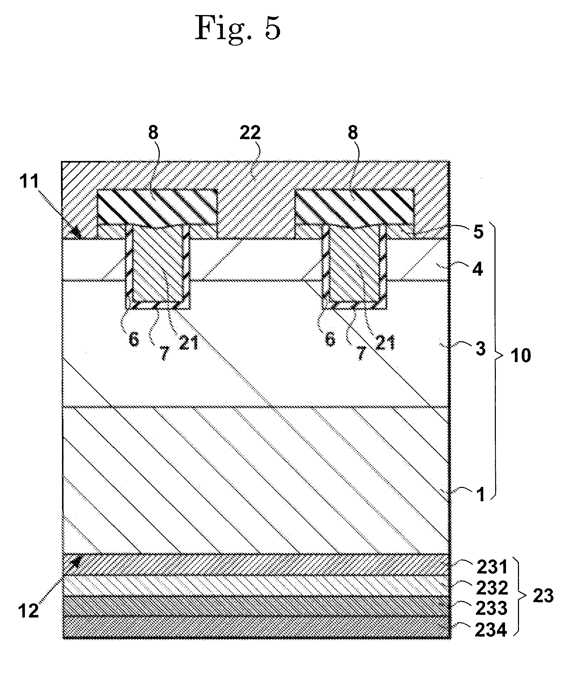

Referring to Fig. 5, the vertical power MOSFET includes the following: a first semiconductor layer 1 having the second conductivity type; a fifth semiconductor layer 3 formed on the first semiconductor layer 1 and having the second conductivity type; a second semiconductor layer 4 formed on the fifth semiconductor layer 3 and having the first conductivity type; a third semiconductor layer 5 formed in the shape of an island on the second semiconductor layer 4 and having the second conductivity type; a dielectric film 7 formed on the second and third semiconductor layers 4 and 5; a control electrode 21 formed on the dielectric film 7; a first main electrode 22 electrically connected to the second and third semiconductor layers 4 and 5; and a second main electrode 23 electrically connected to the first semiconductor layer 1 and having a Pd layer.

In the mode 2, the first conductivity type is the p type while the second conductivity type is the n type, similarly in the mode 1. Specifically, the first semiconductor layer 1 of the second conductivity type is an n+ type substrate (a drain layer). The fifth semiconductor layer 3 of the second conductivity type is an n type drain layer. The second semiconductor layer 4 of the first conductivity type is an n type body layer. The third semiconductor layer 5 of the second conductivity type is an n+ type source layer. The control electrode 21 functions as a gate electrode. The first semiconductor layer 1, fifth semiconductor layer 3, second semiconductor layer 4, third semiconductor layer 5, dielectric film 7 and control electrode 21 constitute the n channel conductivity type vertical power MOSFET.

The second main electrode 23 of the mode 2 is similar to that of the mode 1, and is constituted by a Pd layer 231, an Ni layer 233 and an Au layer 234 which are stacked in series. It is assumed here that the arsenic (As) doped first semiconductor layer 1 is used. The Schottky contact is accomplished by directly contacting metal such as Ti to the first semiconductor layer 1. In the mode 2, the Pd layer 231 or a silicide layer is directly contacted to the main surface 12 of the first semiconductor layer 1, so that the Ohmic contact is accomplished as in the semiconductor device of the mode 1. The semiconductor device of the mode 2 is as effective and advantageous as that of the mode 1.

The invention is applicable not only to the n channel type vertical power MOSFET but also to a p channel type vertical power MOSFET. Further, the invention is not limited to the MOSFET having the dielectric film 7 made of an oxide film but is applicable to a MISFET (Metal Insulator Semiconductor Field Effect Transistor) having a dielectric film made of a nitride film or an oxy nitride film. Still further, the invention is applicable to a vertical power MOSFET of the planar structure as well as the vertical power MOSFET of the trench structure.

### [Industrial Applicability]

The invention is applicable to the semiconductor device which can prevent the latch-up phenomenon and accomplish a low on-state voltage, and to the method of fabricating the semiconductor device with good yields.

### [Explanation of Reference Numerals]

- 1: First semiconductor layer
- 2: Fourth semiconductor layer
- 3: Fifth semiconductor layer
- 4: Second semiconductor layer
- 5: Third semiconductor layer
- 6: Trench
- 7: Dielectric film
- 8: Interlayer dielectric film
- 10: Semiconductor layer
- 21: Control electrode
- 22: First main electrode
- 23: Second main electrode
- 231: Pd layer
- 232: Ti layer
- 233: Ni layer
- 234: Au layer

## Claims

1. A semiconductor device comprising:
a first semiconductor layer having a first conductivity type or a second conductivity type opposite to the first conductivity type;
a second semiconductor layer formed on the first semiconductor layer and
having the first conductivity type;
a third semiconductor layer formed in the shape of an island on the second semiconductor layer and having the second conductivity type;
a dielectric film formed on the second semiconductor layer and the third semiconductor layer;
a control electrode formed on the dielectric film;
a first main electrode electrically connected to the second semiconductor layer and the third semiconductor layer; and
a second main electrode electrically connected to the first semiconductor layer and having a Pd layer.

2. The semiconductor device according to claim 1, wherein the second main electrode extends all over a rear surface which is opposite to a front surface of the first semiconductor layer where the second semiconductor layer is present.

3. The semiconductor device according to claim 1 or 2, wherein the second main electrode includes a Pd silicide layer.

4. The semiconductor device according to any one of claims 1 to 3, wherein the second main electrodes includes the Pd layer or the Pd silicide layer on the first semiconductor layer, a Ti layer on the Pd layer or the Pd silicide layer, and an Ni layer on the Ti layer.

5. The semiconductor device according to claim 4, wherein the second main electrode also includes an Au layer on the Ni layer.

6. The semiconductor device according to any one of claims 1 to 5 further comprising an IGBT which includes a collector layer constituted by the first semiconductor layer, a base layer constituted by the second semiconductor layer, and an emitter layer constituted by the third semiconductor layer.

7. The semiconductor device according to any one of claims 1 to 5 further comprising a MOSFET which includes a drain layer constituted by the first semiconductor layer, a body layer constituted by the second semiconductor layer, and a source layer constituted by the third semiconductor layer.

8. A method of fabricating a semiconductor device, the method comprising:
forming a first semiconductor layer having a first conductivity type or a second conductivity type opposite to the first conductivity type;
forming a second semiconductor layer on the first semiconductor layer, the second semiconductor layer having the first conductivity type;
forming a third semiconductor layer in the shape of an island on the second semiconductor layer, the third semiconductor layer having the second conductivity type;
forming a dielectric film on the second semiconductor layer and the third semiconductor layer;
forming a control electrode on the dielectric film;
forming a first main electrode on the second semiconductor layer and the third semiconductor layer; and
forming a second main electrode on the first semiconductor layer, the second main electrode having a Pd layer.

9. The method according to claim 8, wherein the second main electrode is formed by stacking a Pd or Pd silicide layer, a Ti layer, and an Ni layer in series on the first semiconductor layer.
